Europäisches Patentamt

European Patent Office

Office européen des brevets

(19)

(11) **EP 0 587 491 B1**

(12)

# FASCICULE DE BREVET EUROPEEN

(45) Date de publication et mention
de la délivrance du brevet:
**22.04.1998 Bulletin 1998/17**

(51) Int Cl.⁶: **G01R 15/00**

(21) Numéro de dépôt: **93402172.6**

(22) Date de dépôt: **07.09.1993**

(54) **Dispositif de mesure utilisant une bobine de Rogowski**

Messanordnung mit Rogowski-Spule

Measuring appliance using Rogowski coil

(84) Etats contractants désignés:
**CH DE FR GB IT LI SE**

(30) Priorité: **10.09.1992 FR 9210801**

(43) Date de publication de la demande:
**16.03.1994 Bulletin 1994/11**

(73) Titulaire: **GEC ALSTHOM T ET D SA**
**75016 Paris (FR)**

(72) Inventeur: **Baudart, Christophe**
**F-69006 Lyon (FR)**

(74) Mandataire: **Fournier, Michel et al**
**c/o ALCATEL ALSTHOM,**
**Département de Propriété Industrielle,**
**30, avenue Kléber**
**75116 Paris (FR)**

(56) Documents cités:
CH-A- 665 303          DE-C- 721 389
US-A- 5 055 816

• PATENT ABSTRACTS OF JAPAN, vol. 9, no. 239
(P-391)(1962), 25 Septembre 1985; & JP-A-60 93
325

## Description

La présente invention concerne l'utilisation d'une bobine de Rogowski réalisée comme celle qui a été décrite dans la demande de brevet français n' 92 06 859 déposée le 5 juin 1992.

Une telle bobine est caractérisée en ce qu'elle comprend au moins une carte de circuit imprimé munie d'une découpe circulaire, le bobinage étant réalisé par des dépôts métalliques rectilignes sur chacune des deux faces de la plaque disposés selon des rayons dont le prolongement passe par le centre de ladite découpe, les liaisons électriques entre les rayons d'une face et ceux de la face opposée étant réalisée par des trous métallisés traversant l'épaisseur de la plaque.

Une telle bobine, dans laquelle le bobinage constitué par les rayons et les trous comporte un aller et un retour autour de la découpe circulaire avec une entrée et une sortie sur une même face de la plaque, séparés par une distance de quelques diziènes de millimètres, possède une parfaite symétrie axiale. En outre, une telle bobine est peu sensible aux variations de température, grâce à l'emploi de la résine époxy comme matériau de support du bobinage.

Un but de l'invention est d'utiliser, d'une manière simple, une telle bobine, de manière à réaliser un dispositif de mesure du courant pratiquement insensible aux variations de température.

La mesure du courant à l'aide d'une bobine de Rogowski se fait habituellement en chargeant la bobine avec une résistance de valeur élevée, en recueillant la tension aux bornes de cette résistance et en intégrant cette tension. C'est cette méthode qui est appliquée en donnant à la résistance de charge une valeur particulière qui rend alors la mesure pratiquement indépendante de la température.

L'invention a pour objet un dispositif pour la mesure d'un courant électrique parcourant un conducteur à l'aide d'une bobine de Rogowski traversée par ledit conducteur, la bobine de Rogowski étant du type comprenant au moins une carte de circuit imprimé munie d'une découpe circulaire, le bobinage étant réalisé par des dépôts métalliques sur chacune des faces de la plaque disposés selon des rayons dont le prolongement passe par le centre de ladite découpe, les liaisons électriques entre les rayons d'une face et ceux de la face opposée étant réalisés par des trous métallisés traversant l'épaisseur de la plaque, le bobinage comportant un aller et retour autour de la découpe avec une entrée et une sortie sur une même face de la plaque, séparés par une distance de quelques millimètres, caractérisé en ce qu'il comprend un dispositif de mesure de la tension U aux bornes d'une résistance R en série avec la bobine de Rogowski, la résistance R ayant une valeur égale à

$$R_o = r_o \, ( \, \alpha_r - \alpha_s - \alpha_R)/ \, \alpha_s$$

dans laquelle :

$R_o$ est la valeur ohmique de la résistance R à une température de référence,
$r_o$ est la valeur ohmique de la résistance de la bobine de Rogowski à ladite température de référence,
$\alpha_r$ est le coefficient de température du matériau conducteur de la bobine de Rogowski,
$\alpha_s$ est le coefficient de température de la sensibilité de la bobine de Rogowski,
$\alpha_R$ est le coeeficient de température de la résistance R,
le courant I à mesurer étant lié à la tension U par la relation:

$$U = j \, s_o \, \omega \, I \, R_o \, / \, (R_o + r_o),$$

$s_o$ désignant la sensibilité de la bobine de Rogowski à ladite température de référence,
j étant le signe de notation complexe tel que $j^2 = -1$,
$\omega$ étant la pulsation du courant à mesurer.

L'invention est maintenant expliquée en détail par la description donnée en référence au dessin annexé dans lequel:

- la figure 1 représente, vue en plan, une bobine de Rogowski du type utilisé dans la présente invention,
- la figure 2 est un schéma expliquant la réalisation du bobinage de la bobine de Rogowski du type précité,
- la figure 3 est une vue en perspective d'une bobine de Rogowski ayant deux plaques actives et une plaque à bornier,
- la figure 4 est un schéma du montage de la bobine de Rogowski en appareil de mesure de tension,

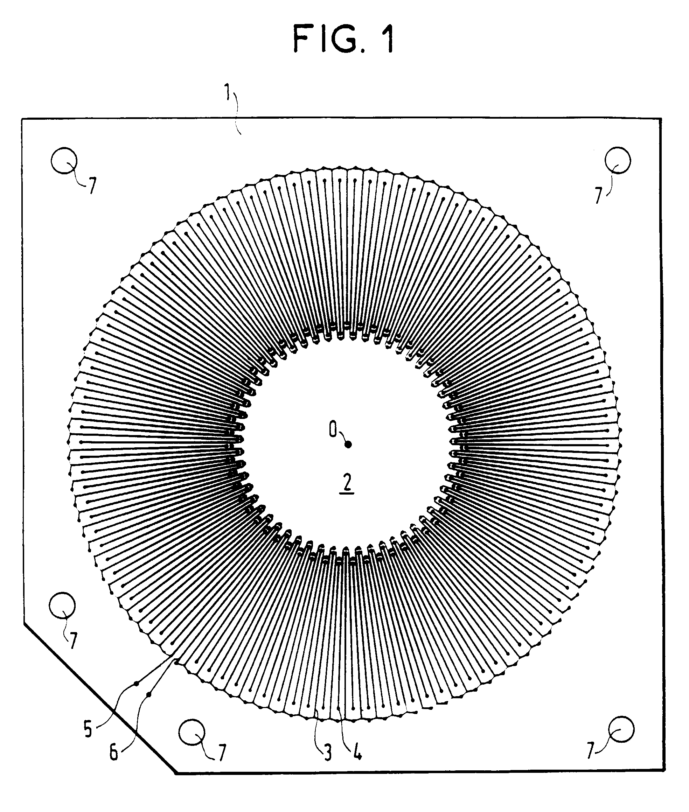

La figure 1 représente, vue en plan une bobine de Rogowski du type utilisé pour réaliser les dispositifs de mesure de l'invention.

Elle comprend une plaque de circuit imprimé double face, de préférence en résine époxy avantageusement chargée de verre stratifié, à faible dilatation thermique. En variante, la plaque est réalisée en céramique ou tout matériau analogue, possédant un coefficient de dilatation très faible.

L'épaisseur de la plaque est avantageusement égale à 1,6 mm.

La plaque, de préférence carrée, comporte un trou central 2 destiné à recevoir le câble dont on désire mesurer le courant.

Le bobinage est constitué de dépôts de cuivre tel que 3, déposés sur chacune des faces de la plaque; ces dépôts sont recitilignes et radiaux, c'est-à-dire que leur prolongement passe par le centre O de la plaque; les dépôts d'une face sont reliés, comme il est décrit plus loin, aux dépôts de la face opposée, par des trous métallisés 4 traversant la plaque.

La surface du dépôt est stabilisée chimiquement par un dépôt d'or d'épaisseur contrôlée, afin de maîtriser la valeur de la résistance interne de la bobine de Rogowski.

L'homme du métier sait remplacer l'or par d'autres dépôts appropriés et protéger ces dépôts par des techniques adéquates, par exemple par des vernis épargnes.

On aperçoit dans la figure 1, l'entrée 5 et la sortie 6 du bobinage, séparés par quelques dixièmes de millimètres pour respecter la symétrie axiale du bobinage.

Les références 7 désignent des trous pour la fixation à la plaque d'autres plaques en vue de la constitution d'un bobine de Rogowski à plusieurs plaques.

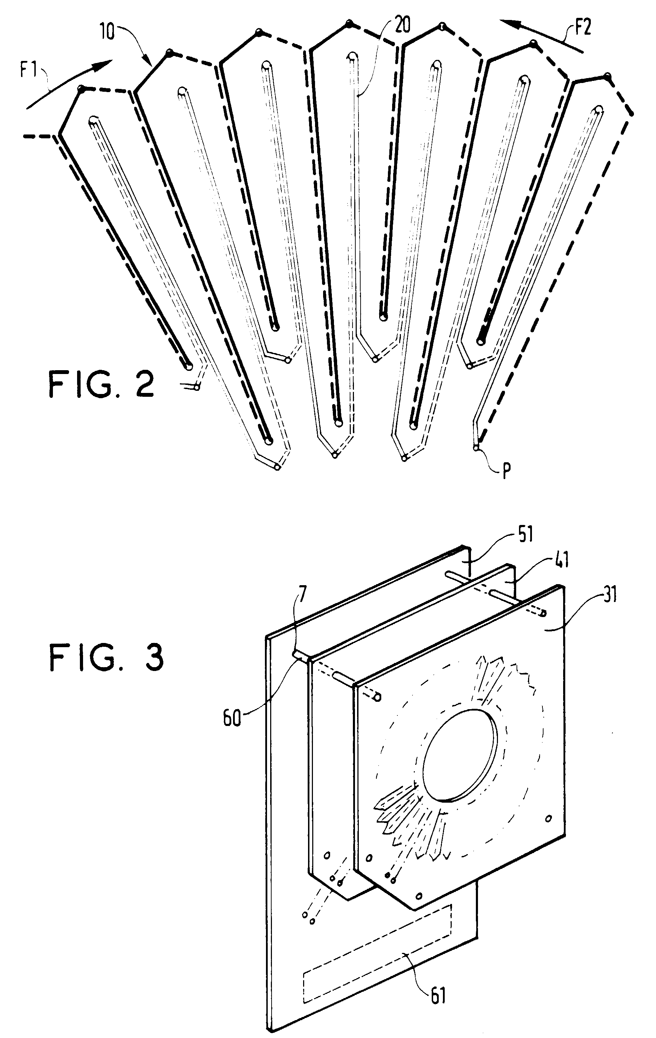

La figure 2 est un schéma expliquant la constitution du bobinage. Pour respecter une parfaite symétrie axiale, le bobinage est constitué de deux enroulements en série, l'un 10, dit premier enroulement, bobiné dans le sens des aiguilles d'une montre, l'autre 20, dit second enroulement, bobiné dans le sens inverse des aiguilles d'une montre.La figure montre schématiquement, vue en plan, une partie de ce bobinage et on a adopté les conventions suivantes: le premier enroulement 10 est représenté en trait épais continu lorsque le dépôt est sur la face visible de la plaque et en trais épais interrompu lorsque le dépôt est sur la face opposée; le second enroulement 20 est représenté en double trait continu ou interrompu selon que le dépôt est sur la face visible ou sur la face opposée. Pour la compréhension du dessin, on a représenté côte-à-côte les deux rayons correspondant à une même spire, mais on doit bien comprendre que ces deux rayons sont exactement situés l'un en face de l'autre sur les deux faces de la plaque. La flèche F1 donne le sens d'enroulement du premier enroulement, la flèche F2 le sens d'enroulerment de l'autre enroulement.Le point P est le point où les enroulements 10 et 20 sont mis en série.

Une plaque de la dimension de celle de la figure 1 (représentée à l'échelle 1/1) peut comporter de l'ordre de 250 spires; il est possible d'accroître la sensibilité de la bobine en utilisant plusieurs cartes du type de celle de la figure 1. La figure 3 montre une bobine comprenant trois cartes bobinées, 31, 41 et 51, disposées parallèlement entre elles, et maintenues solidaires par des tirants 60 passant par les trous 7;les cartes 31 et 41 portent des découpes triangulaires de dimensions inégales, pour faciliter les connexions des bobines, réalisées à l'aide de conducteurs non représentés traversant les plaques perpendiculairement à laur plan.

La plaque 51, qui ne porte pas de découpe, est dans l'exemple de la figure 3, rectangulaire et porte le circuit électronique de traitement des signaux induits dans la bobine de Rogowski, ce circuit étant symbolisé par le rectangle 61. De la sorte, les connexions sont très courtes et n'induisent pas de signaux perturbateurs.

On notera que les connexions de sortie sont réalisées à l'aide de pistes (dépôts métalliques) situées d'un même côté de la plaque, de manière à minimiser l'influence du champ magnétiquecréé par le courant à mesurer.

Lorsque la bobine de Rogowski du type précité est chargée par une très haute impédance (fonctionnement en circuit ouvert) la tension recueillie à ses bornes est de la forme:

$$e = s\ \omega\ I = s.2\pi.f.I$$

dans lequel I est l'intensité du courant à mesurer, $\omega$ sa pulsation, f sa fréquence et s un coefficient de proportionnalité dépendant de la bobine et appelé sensibilité de la bobine.

La variation thermique de la sensibilité s peut se traduire sous la forme

$$s = s_o\ (\ 1 + \alpha_s \Delta\theta)$$

avec:

$s_o$ : sensibilité de la bobine à une température de référence,

$\alpha_s$ : coefficient de température,

$\Delta\theta$ : écart de température par rapport à la température de référence.

Pour une bobine du types précité, la valeur de $\alpha_s$ est voisine de $60 .10\text{-}6/°C$ .

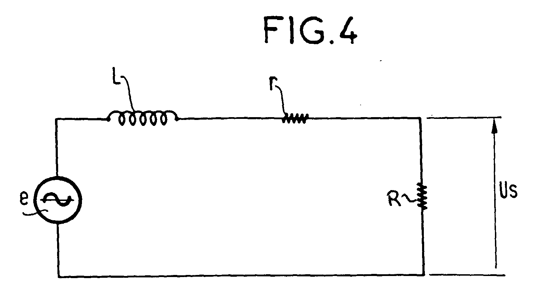

La figure 4 représente le schéma électrique du dispositif de mesure de l'intensité de l'invention. Il comprend une bobine de Rogowski du type précité, équivalente à une source alternative e en série avec une résistance r (valeur ohmique de la résistance de la bobine) et une inductance L (valeur de l'auto-inductance de la bobine égale à Ns, N étant le nombre de spires de la bobine), chargé par une résistance R, et un appareil de mesure de la tension $U_s$ aux bornes de la résistance.

La tension Us est liée au courant par la relation:

$$U_s = j\ s\ \omega\ I\ R\ /\ (R + r +jL\omega)$$

Si on désigne par $\alpha R$ le coefficient de température de la résistance R tel que $R = R_o( 1 + \alpha R\ \Delta\theta)$ et par $\alpha_r$ le coefficient de température de la résistance r de la bobine tel que $r = r_o\ (\ 1 + \alpha r\ \Delta\theta)$, il vient:

$$Us = js_o\omega I\ C/D$$

avec :

$$C = (1+\alpha_s\Delta\theta)R_o(1+\alpha_R\Delta\theta)$$

$$D = R_o(1+\alpha_R\Delta\theta) + r_o(1+\alpha r\Delta\theta) + jNs_o\omega(1+\alpha_s\Delta\theta)$$

En développant le calcul, en négligeant $\alpha_R$ (voisin de $5.10^{-6}$/°C) vis-à-vis de $\alpha_s$ (voisin, comme on l'a déjà indiqué, de $60.10^{-6}$/°C) et en prenant:

$$Ro = r_o ( \alpha_r - \alpha_s - \alpha_R)/\alpha_s,$$

il vient, en négligeant les termes du deuxième ordre $\alpha_r\alpha_s$ $(\Delta\theta)^2$ :

$$Us = (js_o\omega l\, R_o/(R_o + r_o)). \, 1/ F$$

avec

$$F = (1 + jNs_o\omega/(R_o+r_o)). ((1+\alpha_o\Delta\theta)/(1+(\alpha_s+\alpha_R)\Delta\theta)$$

En prenant les approximations suivantes: $\alpha_R\alpha_s\Delta\theta^2$ très inférieur à $(\alpha_R+\alpha_s)\Delta\theta$ et $(\alpha s+\alpha R)\Delta\theta$ très inférieur à 1, il vient:

$$Us = js_o\omega(R_o/(r_o+R_o)/ (1+jNs_o\omega(1-\alpha_R \Delta\theta)/(R_o +r_o))$$

En conclusion, l'amplitude de la tension mesurée est indépendante de la température; si on choisit $\alpha R <$ 5 ppm/°C (résistance NiCr), la phase, définie par la relation

$$\phi_s = arctg ( Ns_o\omega(1 - \alpha_R\Delta\theta)/ (R_o +r_o))$$

varie très peu avec la température.

## Revendications

1. Dispositif pour la mesure d'un courant électrique parcourant un conducteur à l'aide d'une bobine de Rogowski traversée par ledit conducteur, la bobine de Rogowski étant du type comprenant au moins une carte de circuit imprimé (31,41) munie d'une découpe circulaire (2), le bobinage étant réalisé par des dépôts métalliques (3) sur chacune des faces de la plaque disposés selon des rayons dont le prolongement passe par le centre de ladite découpe, les liaisons électriques entre les rayons d'une face et ceux de la face opposée étant réalisés par des trous métallisés (4) traversant l'épaisseur de la plaque, le bobinage comportant un aller et retour autour de la découpe avec une entrée (5) et une sortie (6) sur une même face de la plaque, séparés par une distance de quelques millimètres, caractérisé en ce qu'il comprend un dispositif de mesure de la tension $U_s$ aux bornes d'une résistance (R) en série avec la bobine de Rogowski (L, r), la résistance R ayant une valeur égale à

$$R_o = r_o ( \alpha_r - \alpha_s - \alpha_R)/ \alpha_s$$

dans laquelle :

$R_o$ est la valeur ohmique de la résistance R à une température de référence,
$r_o$ est la valeur ohmique de la résistance de la bobine de Rogowski à ladite température de référence,
$\alpha_R$ est le coefficient de température du matériau conducteur de la bobine de Rogowski,
$\alpha_s$ est le coefficient de température de la sensibilité de la bobine de Rogowski,
$\alpha_R$ est le coeeficient de température de la résistance R,
le courant I à mesurer étant lié à la tension $U_s$ par la relation:

$$U_s = j s_o\, \omega\, I\, R_o / (R_o + r_o) ,$$

so désignant la sensibilité de la bobine de Rogowski à ladite température de référence,
j étant le signe de notation complexe tel que $j^2 = -1$, $\omega$ étant la pulsation du courant à mesurer.

## Patentansprüche

1. Anordnung zur Messung eines elektrischen Stroms, der durch einen Leiter fließt, mit Hilfe einer Rogowski-Spule, durch die der Leiter hindurchgeht, wobei die Rogowski-Spule von dem Typ ist, der wenigstens eine mit einem kreisförmigen Ausschnitt (2) versehene Leiterplatte (31, 41) umfaßt, wobei die Bewicklung durch Metallablagerungen (3) auf jeder der Seiten der Platte ausgeführt ist, die entlang der Radien angeordnet sind, deren Verlängerung durch den Mittelpunkt des Ausschnitts geht, wobei die elektrischen Verbindungen zwischen den Radien einer Seite und denen der entgegengesetzten Seite durch metallisierte Löcher (4) ausgeführt sind, die durch die Dicke der Platte hindurchgehen, wobei die Bewicklung einen Vor- und Rückgang um den Ausschnitt mit einem Eingang (5) und einem Ausgang (6) auf derselben Seite der Platte aufweist, die durch einen Abstand von einigen Millimetern getrennt sind, dadurch gekennzeichnet, daß sie eine Meßanordnung für die Spannung $U_s$ an den Anschlußklemmen eines Widerstands (R) in Reihe mit der Rogowski-Spule (L, r) umfaßt, wobei der Widerstand R einen Wert gleich

$$R_o = r_o \, (\alpha_r - \alpha_s - \alpha_R)/ \, \alpha_s$$

hat, worin

R$_o$ der ohmsche Wert des Widerstands R bei einer Bezugstemperatur ist,

r$_o$ der ohmsche Wert des Widerstands der Rogowski-Spule bei der Bezugstemperatur ist,

$\alpha_R$ der Temperaturkoeffizient des leitenden Materials der Rogowski-Spule ist,

$\alpha_s$ der Temperaturkoeffizient der Empfindlichkeit der Rogowski-Spule ist,

$\alpha_R$ der Temperaturkoeffizient des Widerstands R ist, wobei der zu messende Strom I mit der Spannung U$_s$ durch die Beziehung

$$U_s = j \, s_o \, \omega \, I \, R_o \, / \, (R_o + r_o)$$

verbunden ist,

wobei s$_o$ die Empfindlichkeit der Rogowski-Spule bei der Bezugstemperatur bezeichnet,

wobei j das Vorzeichen der komplexe Schreibweise so ist, daß j$^2$ = -1,

wobei $\omega$ die Kreisfrequenz des zu messenden Stroms ist.

**Claims**

1. Device for measuring an electrical current in a conductor using a Rogowski coil through which said conductor passes, the Rogowski coil being of the type comprising at least one printed circuit plate (31, 41) provided with a circular cutout (2), the coil being implemented by metal deposits (3) on each of the two faces of the plate and extending along radii such that geometrical projections thereof pass through the centre of said cutout, electrical connections between the radii on one face and those on the opposite face being implemented by plated-through holes (4) that pass through the thickness of the plate, the winding comprising an outward leg and a return leg around the cutout with an input (5) and an output (6) on the same face of the plate, separated by a distance of a few millimetres, characterised in that it comprises a device for measuring the voltage U$_s$ across a resistor (R) in series with the Rogowski coil (L, r), the resistor R having a value equal to

$$R_0 = r_0 \, (\alpha_r - \alpha_s - \alpha_R)/\alpha_s$$

where:

R$_0$ is the ohmic resistance of the resistor R at a reference temperature,
r$_0$ is the ohmic resistance of the Rogowski coil at said reference temperature,
$\alpha_r$ is the temperature coefficient of the conductive material of the Rogowski coil,
$\alpha_s$ is the temperature coefficient of the sensitivity of the Rogowski coil,
$\alpha_R$ is the temperature coefficient of the resistor R,
the current I to be measured being related to the voltage U$_s$ by the equation:

$$U_s = j \, s_0 \, \omega \, I \, R_0 \, / \, (R_0 + r_0)$$

where:

s$_0$ is the sensitivity of the Rogowski coil at said reference temperature,
i is the complex operator such that j$^2$ = -1, and
$\omega$ is the angular frequency of the current to be measured.

# FIG. 1

FIG. 2

FIG. 3

# FIG.4